# EUROPEAN PATENT APPLICATION

(11) **EP 3 660 414 A1**
(43) Date of publication of application: **03.06.2020**
(21) Application number: 17919871.8
(22) Date of filing: 04.08.2017
(51) Int. Cl.: F24S 10/75

(54) **VERTICAL SOLAR APPARATUS**

(71) Applicant: Bolymedia Holdings Co. Ltd., Santa Clara, California 95051 (US)
(72) Inventor: HU, Xiaoping, Shenzhen Guangdong 518055 (CN)
(74) Representative: Manitz Finsterwald Patent- und Rechtsanwaltspartnerschaft mbB
(86) International application number: PCT/CN2017/095983
(87) International publication number: WO 2019/024080

(57) **Abstract**

Disclosed is a vertical solar apparatus, comprising a vertical light guide device (110) and a light energy utilization device (120), wherein the vertical light guide device (110) comprises at least one Fresnel lens (111, 112) arranged substantially vertically; and the light energy utilization device has a second light receiving surface (Fa2) substantially laid out flat. The light guide device is used for deflecting sunlight, such that the sunlight is at least partially guided to the second light receiving surface (Fa2). The solar apparatus can be adapted in order to be mounted in a long and narrow zone, and a vertical structure thereof enables the solar apparatus to easily engage with an elevation of a building, thereby saving on an additional occupied area.

## Description

### TECHNICAL FIELD

The present disclosure relates to clean energy, in particular to vertical solar apparatus installed upright.

### BACKGROUND

Solar systems have been growing in popularity with increasing focus on environmental protection.

Most of available solar systems are in a horizontal arrangement due to each area of their light receiving surfaces being directly proportional to the input of solar energy. Only in areas with higher latitudes, such as the North Pole and South Pole, would the photovoltaic panels of the solar systems be set to have a larger angle with the horizon. While in other vast regions, the angles between the photovoltaic panels and the horizon are usually less than 45 degrees so as to obtain higher light energy utilization efficiency.

Since the solar system arranged flat has a larger footprint, it is difficult to fix up the solar system in regions with high population densities, especially in large cities where the solar devices are hard to be promoted and utilized due to the requirement for large hand occupation. And if a solar power station is built in a remote area, it may bring problems in power transmission and management.

Therefore, it is necessary to study solar energy apparatus that are more space-saving and easy to arrange.

### SUMMARY

A vertical solar provided according to the present disclosure may include a vertical light guiding device and a light energy utilizing device. The vertical light guiding device has a thickness and a height greater than the thickness and has a substantially upright first light receiving surface configured for receiving sunlight. The light energy utilizing device has a second light receiving surface laid substantially flat and configured for receiving sunlight. The second light receiving surface has an area smaller than that of the first light receiving surface and is arranged on a side of the first light receiving surface. The vertical light guiding device may comprise at least one Fresnel lens arranged substantially vertically, and the vertical light guiding device is configured for deflecting sunlight reaching the first light receiving surface and guiding it at least partially to the second light receiving surface.

The terms "vertical" and "laid flat" as used herein are relative concepts. When the angle between the normal of the light receiving surface and the direction of gravity of the location is greater than 60 degrees, it can be regarded as "substantially vertical". And When the angle between the normal of the light receiving surface and the direction of gravity of the location is less than 30 degrees, it can be regarded as "substantially laid flat".

### (Beneficial effect)

The solar device according to the present disclosure can be applied to be mounted in a long and narrow zone (such as two sides of a highway, the edge of a river or a lake) due to its vertical structure. And the vertical structure makes it easy to engage with the facade of other buildings (such as fences, fences, building exterior walls, etc.), which can go beyond elimination of independent brackets required for traditional solar installations, and extend to improvement of wind resistance of the solar apparatus. It also greatly saves additional occupied space, which is very advantageous for cities with very high population densities.

Hereinafter, specific examples according to the present invention will be described in detail with reference to the accompanying drawings. Terms used to indicate position, such as "upper", "lower", "top", "bottom", etc., only indicate relative positional relationships and do not have absolute meanings. The numbers or serial numbers used herein, such as "first", "second", etc., are for identification purposes only and do not have any restrictive meaning.

### BRIEF DESCRIPTION OF THE DRAWINGS

FIG. 1 is a schematic diagram of a vertical solar apparatus according to Embodiment 1;
FIG. 2 is a schematic diagram of two patterns of a tooth surface of a Fresnel lens in the present disclosure;
FIG. 3 is a schematic diagram of a vertical solar apparatus according to Embodiment 2;
FIG. 4 is a schematic diagram of a vertical solar apparatus according to Embodiment 3;
FIG. 5 is a schematic diagram of a vertical solar apparatus of Embodiment 4;
FIG. 6 is a schematic diagram of a vertical solar apparatus of Embodiment 5;
FIG. 7 is a schematic diagram of a vertical solar apparatus according to Embodiment 6.

### DETAILED DESCRIPTION

### Embodiment 1

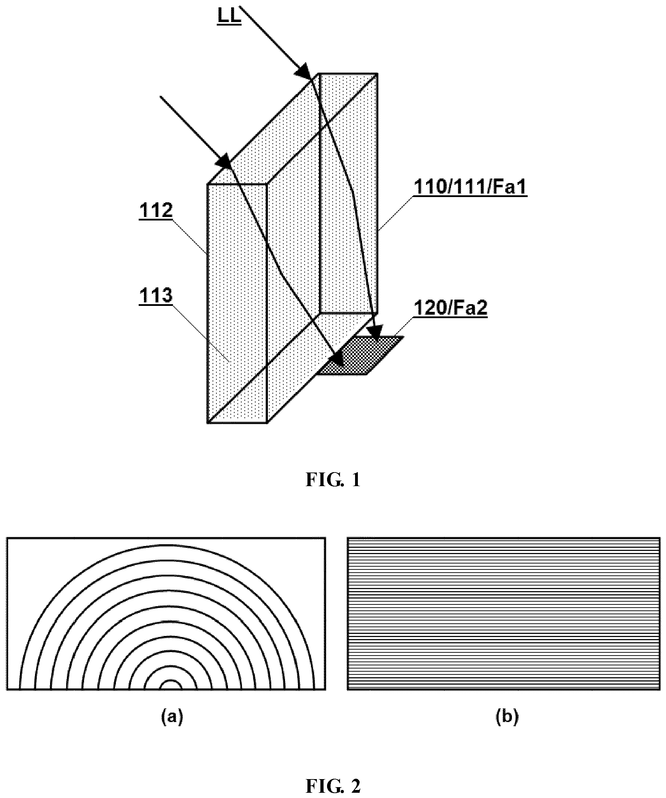

Referring to FIG. 1 a vertical solar apparatus according to an embodiment of the present disclosure may include a vertical light guiding device 110 and a light energy utilizing device 120.

The vertical light guiding device 110, having a thickness and a height larger than the thickness, is provided with an essentially-vertical first light receiving surface Fa1 for receiving sunlight. In this embodiment, the vertical light guiding device includes two Fresnel lenses 111, 112 which are arranged substantially uprightly and formed as walls facing each other. Any one wall surface of the Fresnel lenses 111, 112 may be regarding as the first light receiving surface. The rear wall surface (which is farther from a light source) of the lens 111 shown in FIG. 1 is taken as an example; in this respect, the thickness of the light guiding device is the distance between the two walls.

In other embodiments, the two upright walls of the light guiding device may also employ a Fresnel lens for only one wall, and the other wall may be formed of a smooth transparent material or a reflector. Or the light guiding device may only include a substantially vertical wall formed by a Fresnel lens; in this respect, the thickness of the light guiding device is only the thickness of the Fresnel lens.

The light energy utilizing device 120 has a second light receiving surface Fa2 laid substantially flat for receiving sunlight. The second light receiving surface, arranged on a side of the first light receiving surface, has an area smaller than that of the first light receiving surface. The sunlight LL is at least partially guided to the second light receiving surface after being deflected by the light guiding device 110.

The light energy utilizing device may refer to various devices that convert light energy into other energy, including a photovoltaic conversing device or a thermal energy utilizing device or a combination thereof. By using the light guiding device to converge light, a higher light-concentration ratio can be generated, hence the light energy utilizing device may include the thermal energy utilizing device. The photovoltaic conversing device may include photovoltaic panels, photovoltaic films, quantum dot photovoltaic panels and the like made of various materials. The thermal energy utilizing device may include thermal energy storage (referring to containers holding heat storage working medium, such as water heaters), thermoelectric conversing devices, Stirling generators, thermal energy generators and so on. In this embodiment, a photovoltaic panel is used as the light energy utilizing device, and its surface is the second light receiving surface. In other embodiments, the photovoltaic conversing device and the thermal energy utilizing device may be used by series to achieve higher solar energy utilization efficiency. For example, the thermal energy utilizing device may be arranged on the back side of the light energy utilizing device or wrap the light energy utilizing device transparently and be thermally connected to the light energy utilizing device.

Fresnel lenses are mainly used as light guiding elements in the present disclosure. Fresnel lenses are thin lenses that are lightweight and convenient for batch production. The vertical light guiding device with Fresnel lens as its main component can increase the light-concentration ratio at a relatively low cost and greatly save the occupation of precious land. The tooth surface of a Fresnel lens is obtained by dividing the smooth refractive surface of an ordinary lens, so the texture of the tooth surface and its corresponding smooth lens surface usually have consistent optical symmetry. The "concentrating" (or "astigmatic") Fresnel lens herein may refer to a Fresnel lens that functionally condenses light toward the optical center of the lens (or diffuses out of the optical center), and its tooth surface usually comes from a convex lens surface (or a concave lens surface). A "linear" Fresnel lens herein including a linear astigmatic Fresnel lens and a linear light-concentrating Fresnel lens means that the focus center of the lens is a line instead of being concentrated at one point. For example, the tooth surface of a linear Fresnel lens may be originated from a concave (or convex) cylindrical surface, or a concave (or convex) polynomial cylindrical surface.

The Fresnel lens used in the present disclosure may be selected from the following: a single-faced Fresnel lens with a toothed surface on one side and a smooth surface on the other, and a double-faced Fresnel lens with toothed surfaces on both sides. For example, in this embodiment, in order to facilitate the cleaning of the apparatus's vertical face, both Fresnel lenses 111, 112 can be single-faced Fresnel lenses with only one tooth surface, and the two tooth surfaces are disposed inwardly opposite each other. For simplicity, in this embodiment, the macroscopic shapes of the tooth surfaces are all flat. The so-called "macroscopic shape" refers to the geometric shape of the Fresnel lens as a whole after ignoring the undulations of the tooth surface; also it can be understood as the shape of the smooth enveloping surface of the Fresnel lens. In other embodiments, the macroscopic shape of the tooth surface may also be a curved surface or a folded surface, which may be determined according to the requirements of the installation place and the optical design.

To favorably converge the sunlight irradiated onto the vertical light receiving surface to the side, a "lateral light focusing" tooth surface (i.e. it has the function of concentrating light rays in a sideways direction) may be adopted as the tooth surface of the vertical lens in a preferred embodiment. Such tooth surface comes from a part of a "complete tooth surface" so that the optical center of the tooth surface is located at the edge (including near the edge). In other words, the "complete tooth surface" can be cut along its optical centerline (for a "linear" lens, it is along its optical center surface), and the "lateral light focusing" tooth surface can be obtained. The so-called "complete tooth surface" refers to a tooth surface derived from a symmetric smooth refractive surface, the optical center of which is consistent with the geometric center; for example, it can be:
a circumferentially symmetrical concentrating or astigmatic tooth surface with a single focal spot,
an axisymmetric linear concentrating or linear astigmatic tooth surface, and
an axisymmetric elliptical concentrating or elliptical astigmatic tooth surface with two focal spots.

A schematic pattern of two "lateral light focusing" tooth surfaces are exemplarily shown in FIG. 2, wherein FIG. 2(a) is a schematic view of approximately half a circumferentially symmetrical tooth surface, and FIG. 2(b) a schematic view of approximately half a linear tooth surface.

In the case where the light guiding device includes multiple tooth surfaces, all the tooth surfaces of the vertical lenses can use the "lateral light focusing" tooth surface, or a part of them employs the complete tooth surface and the other part the "lateral light focusing" tooth surface. For example, the last vertical tooth surface located in front of the second light receiving surface may be arranged as the "lateral light focusing" tooth surface.

It is worth mentioning that the "lateral light focusing" tooth surface may not only be a part cut from the concentrating tooth surface (the subsequent light path follows the deflection direction of the concentrated light), but also be a part cut from the astigmatic tooth surface (the subsequent light path follows the deflection direction of its divergent light), which unexpectedly achieves focusing light rays laterally by means of a part of the astigmatic tooth surface according to the present disclosure

Preferably, the vertical light guiding device 110 in this embodiment is formed as a closed cavity, which may go beyond convenience for cleaning and maintenance, and extend to enhancement of the overall strength of the apparatus. Further preferably, the closed cavity may also be filled with a gas 113, such as a high-pressure gas (i.e. a gas having a pressure greater than one atmospheric pressure) or an optical gas (i.e. a gas having a refractive index greater than that of air under identical physical conditions). Filling with high-pressure gas helps to increase the strength of the apparatus against external forces, while filling with optical gas can support the light guiding device to increase light convergence. In addition, non-optical gas may be pressurized to have a refractive index greater than 1.

In other embodiments, the light energy utilizing device may be arranged inside the closed cavity of the light guiding device, or the second light receiving surface may be formed as a part of the inner surface of the closed cavity. A reflecting surface may also be introduced in the light guiding device to achieve a richer and more flexible optical design; for example, any Fresnel lens vertically arranged can make it a reflective Fresnel lens by forming the side of the lens facing away from the second light receiving surface to be a reflecting surface; or providing a reflecting surface by using a fixed or movable reflecting device.

The shape of the vertical light guiding apparatus in this embodiment is a pillar extending in the vertical direction, and its cross-sectional shape is rectangular, which is suitable for being arranged along a narrow and long zone or on a flat building facade. The vertical light guiding apparatus in other embodiments may also be in different shapes according to the needs of the application scenario, such as a wedge shape, or a pillar extended horizontally. The cross-sectional shape perpendicular to the extension direction of the pillar may be selected from the group consisting of a circle, a square, a rectangle, an oval, a hexagon and an octagon. When the pillar extends vertically, the first light receiving surface is formed on the surface of the pillar; and when the pillar extends in the horizontal direction, the first light receiving surface is formed on the upright wall surface (or end surface).

### Embodiment 2

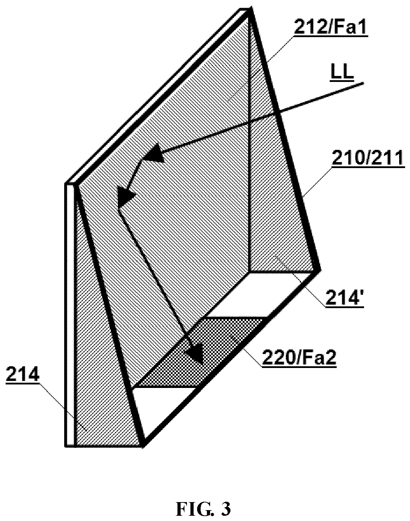

Referring to FIG. 3, a vertical solar apparatus according to another embodiment of the present disclosure includes a vertical light guiding device 210 and a light energy utilizing device 220.

The vertical light guiding device 210 has a wedge shape and includes two Fresnel lenses 211, 212 arranged substantially vertically and formed as walls facing each other. The lenses 211, 212 are single-faced Fresnel lenses with tooth surfaces arranged inwardly opposite each other, and smooth back surfaces outward. The tooth surface of the lens 212 can be regarded as the first light receiving surface Fa1. The lens 212 is a reflective Fresnel lens, and its smooth back surface facing outward is a reflecting surface.

The light energy utilizing device 220 is arranged at the bottom of the wedge, forming as a whole with the structure of the light guiding device, thereby providing a low-cost and high-performance vertical solar apparatus.

Preferably, the light guiding device 210 in this embodiment further includes reflectors 214, 214' arranged on both sides of the first light receiving surface. These reflectors can better converge sunlight toward the second light receiving surface when the sun is deflected in a direction parallel to the first light receiving surface.

The wedge-shaped structure of the apparatus in this embodiment makes it difficult for dust to accumulate, and the facade can be washed well by rainwater. Therefore, in regions with normal rainfall, it is almost unnecessary to clean the light receiving surface.

### Embodiment 3

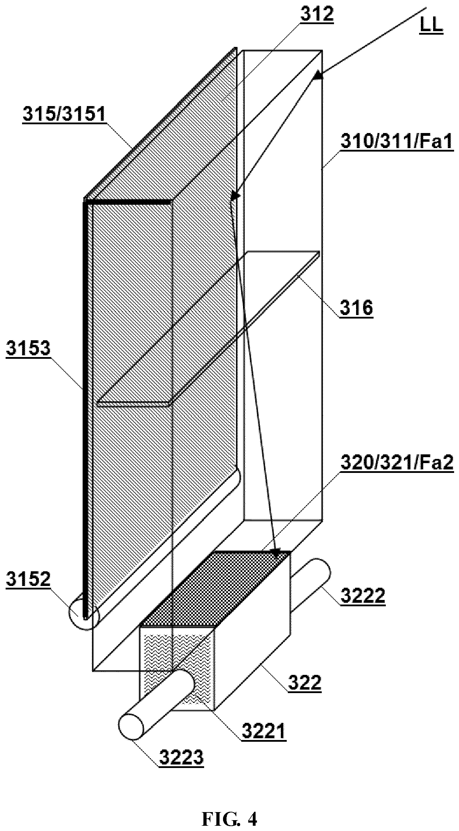

Referring to FIG. 4, a vertical solar apparatus according to still another embodiment of the present disclosure includes a vertical light guiding device 310 and a light energy utilizing device 320.

The vertical light guiding device 310 has a rectangular column appearance and includes two Fresnel lenses 311, 312 arranged substantially vertically and formed as walls facing each other. The lenses 311, 312 are single-faced or double-faced Fresnel lenses. The outer surface of the lens 311 may be regarded as the first light receiving surface Fa1.

The light energy utilizing device 320 is a combination of a photovoltaic panel 321 and a thermal energy utilizing device 322. The photovoltaic panel 321 is arranged at the bottom of the light guiding device, and its surface is the second light receiving surface Fa2. The thermal energy utilizing device 322 is arranged on the back side of the photovoltaic panel, and the working medium 3221 therein exchanges heat with the photovoltaic panel through a thermally conductive connection. The working medium 3221 can perform material or heat exchange with an external system through an inflow pipe 3222 and an outflow pipe 3223. For example, the thermal energy utilizing device 322 may be part of a hot water supply system or a thermal energy generator.

In a preferred embodiment, the vertical light guiding device 310 may further include a curtain-type reflecting device 315 and a Fresnel lens 316 arranged substantially horizontally.

The reflecting device 315 includes a curtain-type reflecting surface 3151 and a driving mechanism composed of a rotating shaft 3152 and a guiding rod 3153. The driving mechanism can drive the curtain-type reflecting surface 3151 to switch between an expanded state and a retracted state, so that the reflecting surface 3151 can movably cover the outer surface of the Fresnel lens 312. This not only helps to reduce the thickness of the apparatus, but also enables the apparatus in this embodiment to better meet the needs of different usage scenarios.

The horizontal Fresnel lens 316 is arranged on the optical path in front of the second light receiving surface, and is disposed on the same side of the first light receiving surface as the second light receiving surface. By setting the horizontal light concentrating lens, the light guiding device can be significantly increased in height to get more solar energy.

### Embodiment 4

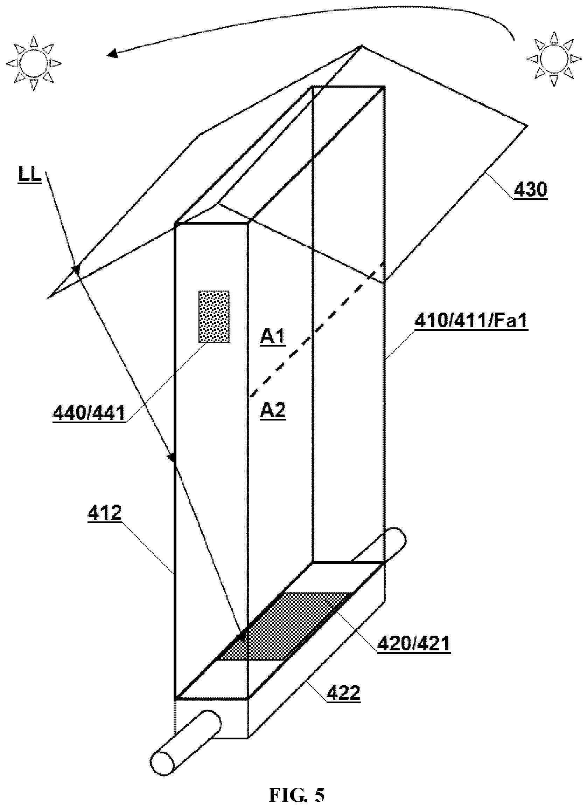

Referring to FIG. 5, a vertical solar apparatus according to yet still another embodiment of the present disclosure includes a vertical light guiding device 410 and a light energy utilizing device 420.

The vertical light guiding device 410 has a rectangular column appearance and includes two Fresnel lenses 411, 412 arranged substantially vertically and formed as walls facing each other. The outer surface of the lens 411 can be regarded as the first light receiving surface Fa1. The tooth surface of the lens 411 in this embodiment adopts a preferred arrangement, that is, it is divided into two regions along the height direction, each region having different focal lengths. In this embodiment, the region A1 at a higher position has a shorter focal length than that of the region A2 at a lower position. This manner can effectively increase the height of the apparatus and the concentration ratio. In other embodiments, the vertical tooth surface can also be divided into more regions with different focal lengths. This manner of setting the focal length by sub-regions can be applied to all or part of the vertical tooth surfaces.

The light energy utilizing device 420 is a combination of a photovoltaic panel 421 and a thermal energy utilizing device 422. Unlike Embodiment 3, the thermal energy utilizing device 422 is integrated at the bottom of the light guiding device 410, so that the light energy utilizing device and the light guiding device are formed as a whole.

The light guiding device in this embodiment does not include a reflecting surface, so sunlight from any direction can be deflected to the bottom thereof through the light guiding device. However, due to the small thickness of the light guiding device, the light receiving area of the light guiding device may be relatively small for sunlight shining in the vertical direction on a sunny noon at low latitudes. Therefore, the solar apparatus in this embodiment may preferably further include a front-end light concentrating device 430arranged above the vertical light guiding device 410 and configured for converging the sunlight shining from above. The lateral dimension of the device 430 is greater than the thickness of the vertical light guiding device 410. The front-end light condensing device 430 in this embodiment is formed in a sloped roof shape, and is operated by a light concentrating Fresnel lens. By providing a front-end light concentrating device with a large lateral size, the apparatus of this embodiment can be better applied to equatorial regions with strong vertical sunlight, effectively increasing power generation. Moreover, the apparatus of this embodiment can also be applicably mounted with the first light receiving surface facing the east-west direction instead of limiting to the north-south direction.

The solar apparatus in this embodiment may preferably further include a piezoelectric vibrator 440 comprising a piezoelectric vibrating piece 441 and a driving circuit (not shown). The piezoelectric vibrating piece is mechanically connected to the light guiding device 410 so as to drive the light receiving surface of the latter to vibrate. Dust is usually not easily deposited on the light receiving surface for a vertical solar apparatus, but it can be shaken off by a vibrator so as to achieve self-cleaning of the light receiving surface. The vibrator may be disposed on an extra-essential light receiving surface, for example, on the side of the light guiding device in this embodiment, as long as it can drive the light receiving surface to vibrate.

### Embodiment 5

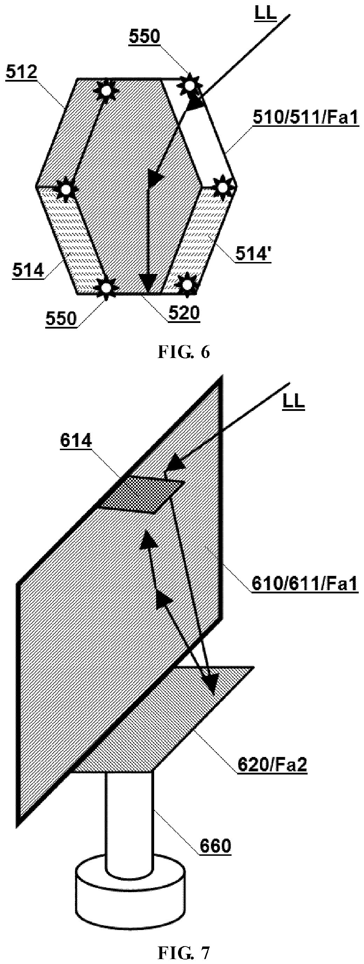

Referring to FIG. 6, the vertical solar apparatus according to still yet another embodiment of the present disclosure includes a vertical light guiding device 510 and a light energy utilizing device 520.

The vertical light guiding device 510 has a column shape extending in a horizontal direction with a hexagonal cross section perpendicular to the extending direction. The light guiding device 510 includes two hexagonal Fresnel lenses 511 and 512 arranged substantially vertically and formed as a closed cavity. The lens 512 is a reflective Fresnel lens with a reflective back surface facing outward. The outer surface of the lens 511 can be regarded as the first light receiving surface Fa1. Each cylindrical surface on the side may be transparent or a reflecting surface. For example, the left and right side surfaces 514 and 514' located on the lower half may be arranged as reflecting surfaces.

The light energy utilizing device 520 (for example, a photovoltaic panel) can be enclosed inside the light guiding device, for example, arranged at the bottom of the light guiding device. This may go beyond safety and extend to making the shape of the entire solar apparatus regular and beautiful.

The solar apparatus in this embodiment may be small in size and have large strength because of its structural characteristics, so it can be used as a solar brick for piling up to form a vertical wall of a building.

The solar brick in this embodiment may preferably further include a plurality of LED lights 550 powered by the photovoltaic panel 520. The built wall can be used for lighting or landscaping, and can also be used as an outdoor information display.

### Embodiment 6

Referring to FIG. 7, a vertical solar apparatus according to another embodiment of the present disclosure includes a vertical light guiding device 610 and a photovoltaic panel 620.

The vertical light guiding device 610 has only one upright wall formed by a Fresnel lens 611. A photovoltaic panel 620 is arranged on one side of the top of the upright wall. The lens 611 is a reflective Fresnel lens. The side of the lens 611 facing the photovoltaic panel can be regarded as the first light receiving surface Fa1, and the side facing away from the photovoltaic panel is a reflecting surface. Preferably, the light guiding device 610 in this embodiment further includes a side reflector 614 arranged substantially flat at the bottom edge of the lens 611, and the reflecting surface thereof faces the second light receiving surface Fa2. The included angle between the reflector 614 and the lens 611 may be slightly less than 90 degrees, so that the light from the lens 611 can be better reflected back and finally converged on the photovoltaic panel 620.

The solar apparatus in this embodiment may preferably further include a substantially vertical rotating shaft 660 on which the entire solar apparatus is mounted on so that the orientation of the first light receiving surface can be adjusted according to the position of the sun. The rotating shaft 660 can be regarded as a sun-tracking system rotating horizontally. By combined utilization with the sun-tracking system, the solar apparatus in this embodiment can excel at light energy receiving efficiency. Compared with a conventional solar system capable of horizontal rotation which needs to increase its height and horizontal size to enlarge light receiving area, to obtain more solar energy, the apparatus of this embodiment only needs to increasing the height dimension.

The principle and implementation manners present disclosure have been described above with reference to the specific examples, which are merely provided for the purpose of understanding the present disclosure and are not intended to limit the present disclosure. It will be possible for those skilled in the art to make variations based on the principle of the present disclosure.

## Claims

1. A vertical solar apparatus comprising:
a vertical light guiding device having a thickness and a height greater than the thickness and provided with a substantially upright first light receiving surface configured for receiving sunlight, and
a light energy utilizing device having a second light receiving surface laid substantially flat and configured for receiving sunlight, the second light receiving surface having an area smaller than that of the first light receiving surface being arranged on a side of the first light receiving surface;
the vertical light guiding device comprising at least one Fresnel lens arranged substantially vertically, and the vertical light guiding device being configured for deflecting sunlight reaching the first light receiving surface and guiding it at least partially to the second light receiving surface.

2. The solar apparatus according to claim 1, wherein
the Fresnel lens is selected from: a single-faced Fresnel lens with a tooth surface on one side and a smooth surface on the other, and a double-faced Fresnel lens with tooth surfaces on both sides;
at least one tooth surface comes from a part of a complete tooth surface such that the optical center of the part is located at an edge thereof, and the complete tooth surface refers to a tooth surface derived from a symmetrical smooth refracting surface with the optical center thereof consistent with geometric center.

3. The solar apparatus according to claim 2, wherein
the complete tooth surface is a concentrating tooth surface or an astigmatic tooth surface, and the complete tooth surface is selected from the group consisting of a circumferentially symmetric tooth surface, a linear tooth surface and an elliptical tooth surface; and
the macroscopic shape of the tooth surface is selected from the group consisting of a flat surface, a curved surface and a folded surface.

4. The solar apparatus according to claim 2, wherein
at least one tooth surface is divided into at least two regions along the height direction, and the region at a higher position region has a shorter focal length.

5. The solar apparatus according to any one of claims 1 to 4, wherein
one of the at least one Fresnel lens arranged substantially vertically is a reflective Fresnel lens with any one side thereof also formed as a reflecting surface; or
the vertical light guiding device further includes a first reflecting device with a reflecting surface thereof which fixedly or movably covered on one surface of a vertical Fresnel lens arranged substantially vertically; or
the vertical light guiding device further includes a second reflecting device with a reflecting surface arranged on the same side of the first light receiving surface as the second light receiving surface.

6. The solar apparatus according to claim 5, wherein
the first reflecting device includes a curtain-type reflecting surface and a driving mechanism which is able to drive the curtain-type reflecting surface to switch between an expanded state and a retracted state.

7. The solar apparatus according to any one of claims 1 to 6, wherein
the vertical light guiding device is formed as a closed cavity with two walls facing opposite to each other, one side of one wall is formed as the first light receiving surface, and one of the two walls is a Fresnel lens or both the two walls are Fresnel lenses.

8. The solar apparatus according to claim 7, wherein
the light energy utilizing device is arranged inside the closed cavity, or the second light receiving surface is formed as a part of an inner surface of the closed cavity.

9. The solar apparatus according to claim 7 or 8, wherein
the closed cavity is filled with a gas having a pressure greater than 1 atmospheric pressure, or a gas having a refractive index greater than 1.

10. The solar apparatus according to any one of claims 1 to 9, wherein
the vertical light guiding device further includes a Fresnel lens arranged substantially horizontally, located on the optical path in front of the second light receiving surface and disposed on the same side of the first light receiving surface as the second light receiving surface.

11. The solar apparatus according to any one of claims 1 to 10, further comprising:
a front-end light concentrating device having a lateral dimension greater than the thickness of the vertical light guiding device, the front-end light concentrating device being arranged above the vertical light guiding device and configured for converging sunlight radiating from above.

12. The solar apparatus according to any one of claims 1 to 11, further comprising:
a rotating shaft arranged substantially vertically on which the apparatus is installed to adjust the orientation of the first light receiving surface according to the position of the sun.

13. The solar apparatus according to any one of claims 1 to 12, wherein the light energy utilizing device is selected from a photovoltaic conversing device or a thermal energy utilizing device or a combination thereof,
when the photoelectric conversing device is used in combination with the thermal energy utilizing device, the thermal energy utilizing device is arranged on the back side of the light energy utilizing device or wraps the light energy utilizing device and is thermally connected to the light energy utilizing device.

14. The solar apparatus according to any one of claims 1 to 13, wherein the shape of the vertical light guiding device is selected from the group consisting of a wedge, a column extending in the vertical direction, and a column extending in the horizontal direction;
the cross-sectional shape of the column perpendicular to the extending direction is selected from the group consisting of: circle, square, rectangle, ellipse, hexagon and octagon; and
when the column extends vertically, the first light receiving surface is formed on the column surface; and when the column extends horizontally, the first light receiving surface is formed on the vertical wall surface.

15. The solar apparatus according to any one of claims 1 to 14, further comprising at least one of the following:
a piezoelectric vibrator comprising a piezoelectric vibrating piece and a driving circuit thereof, the piezoelectric vibrating piece being mechanically connected to the vertical light guiding device to drive its light receiving surface to vibrate; and
at least one LED light powered by a photovoltaic conversing device included in the light energy utilizing device.
